# EUROPEAN PATENT APPLICATION

(11) **EP 2 355 253 A1**
(43) Date of publication of application: **10.08.2011**
(21) Application number: 09827424.4
(22) Date of filing: 27.08.2009
(51) Int. Cl.: H01R 11/01, C08J 5/18, C09J 4/02, C09J 7/00, C09J 9/02, C09J 171/10, H01B 5/00, H01B 5/16, H05K 1/14

(54) **ANISOTROPIC CONDUCTIVE FILM**

(30) Priority: 18.11.2008 JP 2008294655
(71) Applicant: Sumitomo Electric Industries, Ltd., Osaka-shi Osaka (JP)
(72) Inventor: YAMAMOTO, Masamichi, Osaka-shi Osaka 554-0024 (JP); OKUDA, Yasuhiro, Osaka-shi Osaka 554-0024 (JP)
(74) Representative: Setna, Rohan P.
(86) International application number: PCT/JP2009/064935
(87) International publication number: WO 2010/058643

(57) **Abstract**

There is provided an anisotropic conductive film that contains a radically polymerizable substance, a polymerization initiator that generates a radical by heating, a phenoxy resin having a molecular weight of 30,000 or more, and electrically conductive particles, wherein the anisotropic conductive film has a DSC exothermic onset temperature of 100°C or lower and a DSC peak temperature of 120°C or lower when measurement is performed at a rate of temperature increase of 10 °C/min. The film is capable of establishing a sufficient electrical connection between circuit boards by heating at a low mounting temperature for a short time and is free from problems such as a reduction in connection performance with time in a high temperature and humidity atmosphere.

## Description

### Technical Field

The present invention relates to an anisotropic conductive film configured to bond two adjacent circuit boards and electrically connect circuits, facing each other, in different circuit boards without causing a short circuit between adjacent circuits in one circuit board.

### Background Art

In recent years, to correspond the miniaturization and higher functions of electric equipment, bonded articles of circuit boards have been used, each of the bonded articles being formed by bonding and electrically connecting a plurality of circuit boards having fine circuits to each other. Anisotropic conductive films have been widely used to bond and electrically connect the circuit boards. For example, Patent Literature 1 discloses an example thereof.

An anisotropic conductive film in which electrically conductive particles are dispersed in an adhesive film composed of a resin is used as such an anisotropic conductive film. The anisotropic conductive film is sandwiched between two circuit boards to be connected and subjected to thermocompression bonding to bond the two circuit boards, thereby electrically connecting circuits facing each other of the two circuit boards. At this time, it is necessary to prevent a short circuit between adjacent circuits in the same circuit board. Accordingly, the anisotropic conductive film is required to have connection performance in which the resistance (connection resistance) between circuits facing each other in the thickness direction is low and to have insulation performance in which a short circuit between adjacent circuits in the planar direction is prevented.

After the production of an anisotropic conductive film, the anisotropic conductive film is usually stored as a film (in particular, in a state of a film wound in a roll shape) until mounting is performed (when the film is sandwiched between two circuit boards). Thus, the anisotropic conductive film desirably has excellent storage stability as a film.

In the case where an anisotropic conductive film having excellent connection performance and insulation performance is used and where the foregoing thermocompression bonding is performed at a predetermined temperature and pressure, bonding and electrical connection between circuits are established, and insulation between adjacent circuits is also ensured. However, an excessively high temperature of thermocompression bonding, i.e., an excessively high mounting temperature for the anisotropic conductive film, causes thermal damage to the circuits and problems due to a thermal expansion and contraction difference and so forth. For example, in the case where a bonded article of circuit boards is placed in a high temperature and humidity atmosphere for prolonged periods of time, problems such as a reduction in connection performance with time arise readily.

### Summary of Invention

### Technical Problem to be Solved by Invention

Accordingly, a lower temperature during thermocompression bonding, i.e., a lower mounting temperature of the anisotropic conductive film, is desirable. Furthermore, in order to increase productivity in mounting, a shorter time required for mounting (i.e., thermocompression bonding) is preferred. Therefore, a demand exists for an anisotropic conductive film that can be mounted by heating at a lower temperature (for a shorter time) than those of conventional anisotropic conductive films, without causing problems such as a reduction in connection performance with time in a high temperature and humidity atmosphere. Furthermore, the anisotropic conductive film is preferably required to also have excellent storage stability.

It is an object of the present invention to provide an anisotropic conductive film that is capable of establishing sufficient electrical connection between circuit boards by heating at a lower mounting temperature for a shorter time than those of conventional anisotropic conductive films, without causing problems such as a reduction in connection performance with time in a high temperature and humidity atmosphere.

### Solution to Problem

The foregoing problems are solved by an anisotropic conductive film (a first invention of the present invention) containing a radically polymerizable substance, a polymerization initiator that generates a radical by heating, a phenoxy resin having a molecular weight of 30,000 or more, and electrically conductive particles, in which the anisotropic conductive film has a DSC exothermic onset temperature of 100°C or lower and a DSC peak temperature of 120°C or lower when measurement is performed at a rate of temperature increase of 10°C/min.

The inventors have conducted intensive studies and have found the following facts: In the case where a film composed of a resin composition containing a phenoxy resin, a radically polymerizable substance, and a polymerization initiator therefor is used as an adhesive film constituting an anisotropic conductive film, appropriate choices of the types and the blending quantities of the film-constituting materials results in a thermosetting reaction initiation temperature of the resin composition of 100°C or lower and a reaction peak temperature of 120°C or lower; and regulating the thermosetting reaction initiation temperature and the reaction peak temperature within the above-described ranges results in a sufficient electrical connection between circuit boards at a low mounting temperature and results in an anisotropic conductive film free from problems such as a reduction in connection performance with time in a high temperature and humidity atmosphere. The findings have led to the completion of the foregoing invention.

The thermosetting reaction initiation temperature is defined as a DSC exothermic onset temperature when measurement is performed at a rate of temperature increase of 10 °C/min. The reaction peak temperature is defined as a DSC peak temperature when measurement is performed at a rate of temperature increase of 10 °C/min. A DSC exothermic onset temperature exceeding 100°C does not result in sufficient connection performance at low mounting temperature conditions, for example, by heating at 140°C for about 10 seconds and disadvantageously causes a reduction in connection performance with time in a high temperature and humidity atmosphere, i.e., causes an increase in resistance between circuits, facing each other, of two circuit boards with time when a bonded article is placed in a high temperature and humidity atmosphere.

At a DSC peak temperature exceeding 120°C, the resistance between circuits, facing each other, of two circuit boards is not low at low mounting temperature conditions, for example, by heating at 140°C for about 10 seconds, thus failing to achieve sufficient connection performance on this point. Meeting the requirements of a DSC exothermic onset temperature of 100°C or lower and a DSC peak temperature of 120°C or lower initiates the thermosetting reaction at a low temperature to rapidly achieve activation, improving reactivity at a low temperature. Thus, excellent connection performance is achieved even at a low mounting temperature. Note that a smaller difference between the DSC exothermic onset temperature and the DSC peak temperature is preferred. Specifically, a difference of 20°C or lower results in more superior connection performance.

The types and the blending quantities of the phenoxy resin, the radically polymerizable substance, and the polymerization initiator are selected within a range such that the DSC exothermic onset temperature is 100°C or lower and the DSC peak temperature is 120°C or lower when measurement is performed at a rate of temperature increase of 10 °C/min. The types and the blending quantities thereof are not particularly limited so long as the requirements are met. They are exemplified below.

The phenoxy resin constituting the anisotropic conductive film of the present invention is a high molecular weight polyhydroxy-polyether synthesized from bisphenol and epihalohydrin. A typical example thereof is a bisphenol A-type phenoxy resin, in which the foregoing bisphenol is bisphenol A. Examples of the phenoxy resin further include bisphenol F-type phenoxy resins, mixed types of bisphenol A-type phenoxy resins and bisphenol F-type phenoxy resins, mixed types of bisphenol A-type phenoxy resins and bisphenol S-type phenoxy resins, fluorene ring-containing phenoxy resins, and caprolactone-modified bisphenol A phenoxy resin.

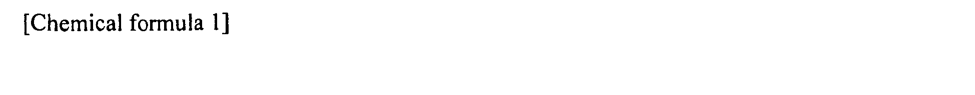

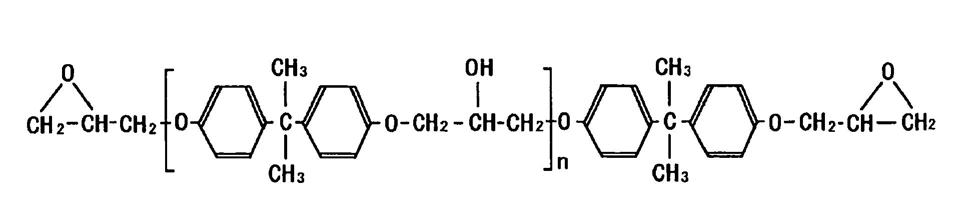

The phenoxy resin has satisfactory toughness, flexibility, adhesion, and excellent film-forming performance and is a component essential for the film formation of the anisotropic conductive film. A phenoxy resin with a larger molecular weight has superior film-forming performance. In the present invention, a phenoxy resin with a molecular weight of 30,000 or more is used to form the anisotropic conductive film. In this case, it is possible to provide excellent film-forming performance and a high adhesive strength. Here, the term "molecular weight" indicates a weight-average molecular weight in terms of polystyrene by gel permeation chromatography (GPC).

The radically polymerizable substance is selected from monomers and oligomers which are radically polymerizable at a mounting temperature, for example, 140°C, and which have compatibility with phenoxy resins each having a molecular weight of 30,000 or more. Examples thereof include acrylic acid esters and methacrylic acid esters. More specific examples thereof include methyl acrylate, ethyl acrylate, isopropyl acrylate, isobutyl acrylate, phenoxyethyl acrylate, phenoxypolyethylene glycol acrylate, polyethylene glycol diacrylate, bisphenol A-type acrylates, such as 2,2-bis[4-(acryloxypolyethoxy)phenyl]propane and 2,2-bis[4-(acryloxydiethoxy)phenyl]propane, bisphenol A-type methacrylates, such as 2,2-bis[4-(methacryloxypolyethoxy)phenyl]propane and 2,2-bis[4-(methacryloxydiethoxy)phenyl]propane, tricyclodecane dimethanol diacrylate, ethoxylated trimethylolpropane triacrylate, trimethylolpropane triacrylate, ethoxylated pentaerythritol tetraacrylate, and methacrylates thereof. These may be used alone or in combination.

The radical polymerization initiator is selected from compounds which are compatible with phenoxy resins each having a molecular weight of 30,000 or more and which are stable at room temperature but have the ability to generate radicals at a mounting temperature, for example, by heating at 140°C and to initiate the polymerization reaction of the radically polymerizable substance. Specific examples thereof include peroxides, ketone peroxides, diacyl peroxides, peroxy dicarbonate, peroxyester, peroxyketal, dialkyl peroxide, and hydroperoxide.

Examples of the electrically conductive particles dispersed in an organic binder component include metal particles composed of gold, silver, copper, nickel, lead, tin, and so forth. Examples thereof further include particles composed of alloys of the metals, such as solder and silver-copper alloys, electrically conductive particles composed of carbon and so forth, and particles each having a core composed of an electrically conductive particle or nonconductive glass, ceramics, or a plastic particle and a coating composed of another conductive material such as a metal or indium tin oxide (ITO) on a surface of the core.

In the case where the electrically conductive particles are deformed by thermocompression bonding (mounting) or where the electrically conductive particles form aggregates, in which case their aggregation structures are changed to deform the aggregates by press bonding, the use of such electrically conductive particles easily improves the connection performance of an anisotropic conductive film, which is preferable: In the case of using a metal having ferromagnetism, the metal is oriented by magnetism itself. Furthermore, the use of the metal having ferromagnetism allows electrically conductive particles composed of the metal to be oriented by means of a magnetic field as described below, thereby easily resulting in an anisotropic conductive film having excellent connection performance, which is preferable.

Preferably, the electrically conductive particles each have a particle diameter of 0.05 to 20 µm. An excessively small particle diameter is liable to cause unstable connection performance. An excessively large particle diameter is liable to cause a short circuit between adjacent circuits to reduce insulation performance.

The blending quantity of the electrically conductive particles is preferably in the range of 0.01% to 20% by volume and more preferably 0.03% to 5% by volume with respect to the total quantity of the radically polymerizable substance, the polymerization initiator that generates radicals by heat, and the phenoxy resin having a molecular weight of 30,000 or more. An excessively large blending quantity of the electrically conductive particles is liable to cause a reduction in insulation performance. An excessively small blending quantity is liable to cause a reduction in connection performance.

According to a second invention of the present invention, in the anisotropic conductive film according to the first invention of the present invention, the anisotropic conductive film has a DSC exothermic onset temperature of 70°C or higher when measurement is performed at a rate of temperature increase of 10 °C/min. An excessively low DSC exothermic onset temperature results in a reduction in the storage stability of the anisotropic conductive film. In particular, storage in the summer months or in tropical areas makes this problem more pronounced. A DSC exothermic onset temperature of 70°C or higher results in sufficient storage stability even for the case of storage in the summer months, in tropical areas, or other high-temperature conditions and is thus preferable.

According to a third invention of the present invention, in the anisotropic conductive film according to the first invention or the second invention of the present invention, the ratio of the length to the diameter of each of the electrically conductive particles is 5 or more.

The use of the electrically conductive particles each having a ratio of the length to the diameter (aspect ratio) of 5 or more as the electrically conductive particles used in the present invention results in excellent connection performance and the enhancement of insulation performance even in the case of a small blending quantity of the electrically conductive particles, which is preferable. The aspect ratio can be directly measured by observation with a charge-coupled device (CCD) microscope.

For the case where each of the electrically conductive particles has a noncircular cross section, the maximum length of the cross section is defined as the diameter, and then the aspect ratio is determined. Each electrically conductive particle is slightly curved or branched, the maximum length of each electrically conductive particle is defined as the length, and then the aspect ratio is determined. An example of the electrically conductive particle having an aspect ratio of 5 or more is an acicular electrically conductive particle. Further examples thereof include an acicular particle in which many fine metal particles are connected to each other. An aspect ratio of 10 to 100 is more preferred.

According to a fourth invention of the present invention, in the anisotropic conductive film according to the third invention of the present invention, the major axes of the electrically conductive particles are oriented with the thickness direction of the anisotropic conductive film.

The orientation of the electrically conductive particles having an aspect ratio of 5 or more in the thickness direction of the film results in further improvement in connection performance and insulation performance and is thus preferable. A method for orienting the electrically conductive particles in the thickness direction of the film is not particularly limited. In the case of using the electrically conductive particles having ferromagnetism, a method is exemplified in which film formation is performed with a magnetic field applied to a resin solution containing electrically conductive particles, as described below, dispersed therein in the direction such that the electrically conductive particles are oriented.

The anisotropic conductive film of the present invention can be produced by, for example, a method in which a dispersion of the electrically conductive particles dispersed in a resin solution of the radically polymerizable substance, the polymerization initiator that generates radical by heat, and the phenoxy resin having a molecular weight of 30,000 or more dissolved in a solvent is applied onto a plate to form a film and then the solvent is removed from the film. The solvent is not particularly limited so long as it can dissolve the radically polymerizable substance, the polymerization initiator, and phenoxy resin and can disperse the electrically conductive particles. The solvent is preferably a solvent that contributes to easy film formation and is readily removed by evaporation owing to its low boiling point.

The anisotropic conductive film of the present invention can be used for bonding and electrical connection between two circuit boards in the same way as conventional anisotropic conductive films. That is, the anisotropic conductive film of the present invention is sandwiched between two circuit boards to be connected and subjected to thermocompression bonding to bond the two circuit boards, thereby electrically connecting circuits facing each other of the two circuit boards. The anisotropic conductive film of the present invention has excellent insulation performance, thus not resulting in a short circuit between adjacent circuits in the same circuit board at this time.

### Advantageous Effects of Invention

The anisotropic conductive film of the present invention is capable of achieving sufficient electrical connection between circuit boards by heating at a low mounting temperature for a short time without causing a problem such as a reduction in connection performance with time in the high temperature and humidity atmosphere.

### Embodiments of Invention

Embodiments for carrying out the invention will be described below by examples. However, the present invention is not limited to these examples.

### EXAMPLES

### (Electrically Conductive Particles)

As electrically conductive particles, straight-chain nickel fine particles having a major axis of 1 µm to 8 µm and a minor axis of 0.1 µm to 0.4 µm were used.

### (Resin Solution)

A bisphenol A phenoxy resin (a phenoxy resin with a molecular weight of 50,000, trade name: Epikote 1256, manufactured by Japan Epoxy Resins Co., Ltd.), 2,2-bis[4-(methacryloxydiethoxy)phenyl]propane (radically polymerizable substance, trade name: BPE-200, manufactured by Shin-Nakamura Chemical Co., Ltd.), and a corresponding one of the following polymerization initiators were mixed in such a manner that compositions (ratio by weight) shown in Table I were achieved. The resulting mixture was dissolved in 2-ethoxyethyl acetate in such a manner that the solid content of a solution was 50% by weight, preparing a resin solution.

### (Polymerization Initiator)

- PERBUTYL O, manufactured by NOF CORPORATION
- PERHEXL O, manufactured by NOF CORPORATION
- PEROCTAH O, manufactured by NOF CORPORATION

Next, 0.1% by volume of the electrically conductive particles were mixed and dispersed in the resulting resin solution. The resulting mixture was applied onto a polyethylene terephthalate film and blow-dried at 60°C, thereby providing an anisotropic conductive film with a thickness of 35 µm.

### (DSC Measurement)

The resulting anisotropic conductive films were subjected to DSC measurement under conditions described below. Table II shows the results.
Apparatus used: differential scanning calorimeter DSC-60, manufactured by Shimadzu Corporation
Measurement condition: rate of temperature increase, 10 °C/min

### (Measurement of Connection Resistance)

A flexible printed circuit board in which 100 gold-plated copper electrodes each having a width of 100 µm and a height of 18 µm were spaced at 100 µm and a glass epoxy board in which 100 gold-plated copper electrodes each having a width of 100 µm and a height of 18 µm were spaced at 100 µm were provided. The resulting anisotropic conductive film was sandwiched between the flexible printed circuit board and the glass epoxy board. They were heat-bonded under a pressure of 3 MPa for 10 seconds while being heated at 140°C, thereby affording a bonded article of the flexible printed circuit board and the glass epoxy board. The resistance between circuits of the flexible printed circuit board and the glass epoxy board was measured. This evaluation was repeated 10 times, and a mean connection resistance was determined. This measurement value is defined as an initial connection resistance and shown in Table II.

### (Heat and Humidity Test)

The foregoing bonded article was placed in a temperature and humidity controlled bath adjusted at a temperature of 85°C and a humidity of 85% and taken out after a lapse of 500 hours. Then a mean connection resistance was determined in the same way as described above. This measurement value was defined as a connection resistance after 500 hr in high temperature and humidity and shown in Table II.

**[Table I]**

| | BPE-200 | Epikote 1256 | Polymerisation initiator (type/blending quantity) | |
|---|---|---|---|---|
| Example 1 | 50 parts | 50 parts | PEROCTAH 0 | 3 parts |
| Example 2 | 50 parts | 50 parts | PERHEXL 0 | 3 parts |
| Comparative Example 1 | 50 parts | 50 parts | PERBUTYL 0 | 3 parts |

**[Table II]**

| | DSC exothermic onset temperature A | DSC peak temperature B | Difference B - A | Initial connection resistance (Ω) | Connection resistance after 500 hr in high temperature and humidity (Q) |
|---|---|---|---|---|---|
| Example 1 | 88 | 102 | 14 | 0.05 | 0.06 |
| Example 2 | 96 | 112 | 16 | 0.06 | 0.07 |
| Comparative Example 1 | 104 | 120 | 16 | 0.06 | open |

As is apparent from Table II, in the case of using the anisotropic conductive films (inventive examples) in Examples 1 and 2, the anisotropic conductive films each having a DSC exothermic onset temperatures of 100°C or lower and a DSC peak temperatures of 120°C or lower (and the differences between the DSC exothermic onset temperatures and the respective DSC peak temperatures are 20°C or lower), the anisotropic conductive films have low initial connection resistances and excellent connection performance even though the bonded articles are produced at a low mounting temperature (heating at 140°C and 3 MPa for 10 seconds). Furthermore, the results shown in Table II demonstrate that the films have low connection resistances after the films are allowed to stand in a high temperature and humidity atmosphere for 500 hours without causing a problem such as a reduction in connection performance with time in the high temperature and humidity atmosphere. In contrast, in Comparative Example 1, in which the DSC exothermic onset temperature exceeds 100°C, the results shown in Table II demonstrate that although the initial connection resistance is low, the connection performance is reduced after the film is allowed to stand in the high temperature and humidity atmosphere for 500 hours.

### Industrial Applicability

The present invention provides an anisotropic conductive film which is capable of establishing a sufficient electrical connection between circuit boards by heating at a lower mounting temperature for a shorter time than those of conventional anisotropic conductive films and which is free from problems such as a reduction in connection performance with time in a high temperature and humidity atmosphere.

### Citation List

### Patent Literature

Patent Literature 1: Japanese Unexamined Patent Application Publication No. 2008-117748

## Claims

1. An anisotropic conductive film comprising a radically polymerizable substance, a polymerization initiator that generates a radical by heating, a phenoxy resin having a molecular weight of 30,000 or more, and electrically conductive particles, wherein the anisotropic conductive film has a DSC exothermic onset temperature of 100°C or lower and a DSC peak temperature of 120°C or lower when measurement is performed at a rate of temperature increase of 10 °C/min.

2. The anisotropic conductive film according to Claim 1, wherein the anisotropic conductive film has a DSC exothermic onset temperature of 70°C or higher.

3. The anisotropic conductive film according to Claim 1 or 2, wherein the ratio of the length to the diameter of each of the electrically conductive particles is 5 or more.

4. The anisotropic conductive film according to Claim 3, wherein the major axes of the electrically conductive particles are oriented with the thickness direction of the anisotropic conductive film.
